# EUROPÄISCHE PATENTSCHRIFT

(11) **EP 1 818 970 B1**
(45) Veröffentlichungstag und Bekanntmachung des Hinweises auf die Patenterteilung: **12.11.2014**
(21) Anmeldenummer: 07008533.7
(22) Anmeldetag: 16.09.2004
(51) Int. Cl.: H01J 37/20, G01N 1/32, B25J 7/00

(54) **Verfahren zur Präparation einer Probe für elektronenmikroskopische Untersuchungen, sowie dabei verwendete Probenträger und Transporthalter**
Method for preparing a sample for electron microscopic investigation, the sample carrier and transport carrier used
Procédé de préparation d'un échantillon pour des recherches électromicroscopiques tout comme porte-échantillon et support de transport ainsi utilisés

(30) Priorität: 17.09.2003 DE 10344643
(43) Veröffentlichungstag der Anmeldung: 15.08.2007
(62) Teilanmeldung aus: 04765266.4
(73) Patentinhaber: Carl Zeiss Microscopy GmbH, 07745 Jena (DE)
(72) Erfinder: Burkhardt, Claus, Dr., 72078 Tübingen (DE); Nisch, Wilfried, Dr., 72070 Tübingen (DE)
(74) Vertreter: Witte, Weller & Partner Patentanwälte mbB

(56) Entgegenhaltungen:
- EP-A- 1 193 216
- EP-A- 1 443 541
- WO-A-01/23092
- WO-A-01/90761
- DE-A1- 4 226 694
- US-A- 6 066 265
- US-A1- 2002 061 662
- US-A1- 2002 166 976
- US-B1- 6 188 068
- AOYAMA H ET AL: "Miniature robot with micro capillary capturing probe" MICRO MACHINE AND HUMAN SCIENCE, 1995. MHS '95., PROCEEDINGS OF THE SI XTH INTERNATIONAL SYMPOSIUM ON NAGOYA, JAPAN 4-6 OCT. 1995, NEW YORK, NY, USA,IEEE, US, 4. Oktober 1995 (1995-10-04), Seiten 173-178, XP010159964 ISBN: 978-0-7803-2676-7
- ARAI F ET AL: "Adhesion-type micro end effector for micromanipulation" ROBOTICS AND AUTOMATION, 1997. PROCEEDINGS., 1997 IEEE INTERNATIONAL C ONFERENCE ON ALBUQUERQUE, NM, USA 20-25 APRIL 1997, NEW YORK, NY, USA,IEEE, US, Bd. 2, 20. April 1997 (1997-04-20), Seiten 1472-1477, XP010235524 ISBN: 978-0-7803-3612-4
- PATENT ABSTRACTS OF JAPAN Bd. 2003, Nr. 05, 12. Mai 2003 (2003-05-12) -& JP 2003 007241 A (NIPPON STEEL CORP), 10. Januar 2003 (2003-01-10)

## Beschreibung

Die vorliegende Erfindung betrifft ein Verfahren zur Präparation einer Probe für elektronenmikroskopische Untersuchungen, insbesondere mit einem Transmissionselektronenmikroskop (TEM) gemäß Anspruch 1.

Ein Verfahren der vorstehend genannten Art ist aus der US 6,188,068 D1 bekannt.

Die Erfindung betrifft ferner einen Greifer mit zwei mikromechanischen Zangenelementen gemäß Anspruch 4.

Mit fortschreitender Miniaturisierung in der Mikro- und Nanotechnologie und insbesondere in der Halbleitertechnik wird die Transmissionselektronenmikroskopie (TEM) innerer Grenzflächen an ionengedünnten Querschliffen immer bedeutender. Dabei ist eine gezielte Präparation einer ausgewählten Objektstelle, also einer an einer Probenstelle des Substrates befindlichen Probe erforderlich. So sind beispielsweise bei zukünftigen MOS Bauelementen Proben bei Gatelängen von 10 nm bis 100 nm und Dicken des Gateoxids von wenigen Atomlagen zielgenau für die hochauflösende TEM zu präparieren.

Auch in vielen Bereichen der Werkstoffwissenschaften wird zunehmend eine Zielpräparation auf bestimmte Mikrobereiche, z.B. Phasenübergänge, Strukturdefekte, Wärmeeinflusszonen, Rissspitzen, Grenzflächen etc. gefordert. Im Bereich der Grenzfläche zwischen Werkstoffen und biologischem Gewebe, wie sie bspw. bei Implantaten auftreten, gibt es bisher ebenfalls keine geeigneten Methoden zur zielgenauen Präparation von Proben für eine nachfolgende TEM.

Um Proben für solche elektronenmikroskopischen Untersuchungen, insbesondere für Untersuchungen mit einem Transmissionselektronenmikroskop (TEM), zu präparieren, ist es erforderlich, sie von ihrem Substrat zu trennen und mechanisch zu fixieren.

Es ist aus dem Stand der Technik bekannt, die Probe hierzu mit Hilfe eines hochenergetischen, fokussierten Ionenstrahls (Focused Ion Beam, FIB) durch physikalisches Ätzen oder chemisch unterstütztes physikalisches Ätzen von dem Substrat zu trennen. Die Probe wird danach mit Hilfe einer Sonde entweder unter einem Lichtmikroskop oder noch in der FIB-Vorrichtung aus dem Substrat entnommen und dann mit Hilfe dieser Sonde an einem Probenträger befestigt; siehe beispielsweise US 6,538,254 B1.

Die US 2003/0089869 A1 beschreibt bspw. ein Verfahren, bei dem die Probe mit FIB von einem Halbleitersubstrat abgetrennt wird, wobei die Stelle, an der die Probe entnommen werden soll, mit Hilfe eines Rasterelektronenmikroskops (REM) abgebildet wird. Die Entnahme der abgetrennten Probe erfolgt mit Hilfe eines elektrostatisch wirkenden Manipulators.

Die US 2002/0121614 A1 beschreibt ein Verfahren, bei dem die Probe in der FIB-Vorrichtung zunächst vollständig von dem Substrat abgetrennt wird, bevor es an der Sonde fixiert wird. Die Sonde kann dabei durch Ionenstrahl-induzierte Ablagerung (IBID) oder Elektronenstrahl-induzierte Ablagerung (EBID) von Material aus einem so genannten Precursor, durch Kleber oder elektrostatisch mit der Probe verbunden werden. Die Probe wird dann bspw. an einen Probenträger übergeben und dort durch Materialablagerung befestigt.

Die EP 1193216 und US 2002/061662 beschreiben Greifen mit zwei Nano-Bachen.

Auch die WO 02/095378 beschreibt ein Verfahren, bei dem die Probe mit Hilfe von FIB sowohl abgebildet als auch vom Substrat abgetrennt wird. Vor dem Abtrennen wird durch IBID eine Sonde an der Probenstelle befestigt. Mit Hilfe eines Mikromanipulators wird die Sonde mit der abgetrennten Probe dann von dem Substrat entfernt und die Probe auf ein TEM-Trägernetz gelegt und dort mit IBID fixiert. Danach wird die Sonde mit Hilfe des Ionenstrahles von der Probe abgetrennt.

Aus der DE 42 26 694 ist ein vergleichbares Verfahren bekannt, bei dem die Probenstelle über Sekundärelektronenemission in einem Rasterionenmikroskop (RIM) abgebildet wird. Die abgetrennte Probe wird durch IBID an der Sonde befestigt und kann dann unter einem REM betrachtet und mit einem abgeschwächten Ionenstrahl weiter bearbeitet werden, um die Probe für die TEM nachzudünnen. Die Sonde weist einen dünnen und kleinen Sondenkopfabschnitt, an dem die Probe befestigt ist, und einen dicken Halteabschnitt auf, an dem sie an einem Mikromanipulator befestigt ist. Die Spitze hat einen Durchmesser von weniger als 10 µm und der als Platte ausgebildete Halteabschnitt eine Dicke von mehr als 50 µm.

Overwijk et al., "Novel scheme for the preparation of transmission electron microscopy specimens with a focused ion beam", J.Vac.Sci.Technol. B 11(6), 1993, Seiten 2021-2024 offenbaren ein Verfahren, bei dem die Probe ebenfalls in einer FIB-Vorrichtung abgebildet und präpariert wird. Um die Oberfläche der Probe beim Abtrennen der Probe durch FIB zu schützen, wird die Probe über IBID mit einer Wolframschicht versehen, die auch als Maske beim Abtrennen dient. Nach dem Abtrennen der Probe von dem Substrat wird das Substrat mit der Probe, die in einer durch FIB in dem Substrat erzeugten Vertiefung enthalten ist, aus der Vakuumkammer entnommen und unter ein Lichtmikroskop gelegt. Dort wird die abgetrennte Probe dann durch Haftwirkung von einer Nadel erfasst und durch vorsichtige Manipulation auf einem TEM-Träger abgelegt.

Die insoweit beschriebenen Verfahren haben jedoch alle den Nachteil, dass die Probe durch die hohe Ionenenergie von üblicherweise 30 keV geschädigt (Armorphisierung) oder verunreinigt (Ionenimplantation) wird. Sie ist dann für eine Untersuchung mittels TEM nur noch bedingt geeignet.

Die Schädigung erfolgt aber nicht nur beim Abtrennen der Probe vom Substrat mittels FIB sondern auch schon beim Aufsuchen der Probenstelle, also bei der Abbildung des die Probenstelle enthaltenden Ausschnittes des Substrates im Ionenrastermikroskop. Bei geringeren Ionenenergien wird die Probenschädigung zwar verringert, allerdings ist bei geringer Ionenenergie die Auflösung bei der Abbildung stark reduziert, so dass ein gezieltes Auffinden einer gewünschten Probenstelle nicht mehr möglich ist.

Ein weiteres Problem stellt die mechanische Handhabung der präparierten Probe dar. Nach der Präparation müssen die winzigen, äußerst fragilen Proben nämlich auf ein TEM-Trägernetz manipuliert werden, was häufig zu einem Verlust der aufwendig präparierten und teuren Proben führt. Häufig ergibt sich auch ein schlechter thermischer und elektrischer Kontakt zwischen Probe und Trägernetz, was zu Abbildungsartefakten durch Aufladung und Aufheizung der Probe führt.

Aus der Veröffentlichung von Matsui und Mori: "New selective deposition technology by electron beam induced surface reaction" in J.Vac.Sci.Technol B4(1), 1986, Seiten 299-304 ist es noch allgemein bekannt, auf einem Substrat in einer Vakuumkammer mit Hilfe eines Elektronenstrahles (EBID) eine Wolframschicht abzulagern, wozu ein Precursor, hier bspw. WF₆, über eine Gasdüse in die Vakuumkammer eingeleitet wird.

Bei dem aus der eingangs genannten US 6,188,068 bekannten Verfahren wird die Probe mit FIB freigeschnitten und dann entweder mit einem TEM-Probenträger verbunden und über diesen von dem Substrat entfernt, oder über eine Sonde entnommen, an der die Probe auf geeignete Weise gehalten wird. Die Probe wird dann auf einem TEM-Probenhalter abgelegt.

Die Erfinder der vorliegenden Anmeldung haben erkannt, dass gerade die Kombination von Schutzschicht und Handling noch in der Vakuumkammer viele Probleme vermeidet, die im Stand der Technik vorherrschen. Durch die Schutzschicht wird die Gefahr einer Schädigung der Probe beim Abtrennen vom Substrat deutlich verringert, während das Handling noch in der Vakuumkammer mechanische Schädigungen vermeidet. In der Vakuumkammer ist es jetzt möglich, die abgetrennte Probe mit großer Sicherheit und Reproduzierbarkeit bspw. durch Adhäsion aufzunehmen. Der im Stand der Technik häufig zu beobachtende Verlust der Probe beim Handling wird so vermieden.

Auch Overwijk et al. beschreiben zwar eine Manipulation der Probe unter Ausnutzung der Haftwirkung an einer Nadelspitze, dies erfolgt jedoch unter einem Lichtmikroskop, also nicht im Vakuum. Die Erfinder der vorliegenden Anmeldung haben nun erkannt, dass die Haftwirkung im Vakuum besser kontrolliert werden kann und reproduzierbarer ist als unter atmosphärischen Bedingungen. Dies liegt nach Erkenntnis der Erfinder an der unter atmosphärischen Bedingungen wechselnden Luftfeuchtigkeit. Je nach Grad der Luftfeuchtigkeit haftet die Probe nämlich besser oder schlechter an der Nadel. Im Vakuum kann der für die Haftung erforderliche Feuchtefilm jetzt gezielt ohne Abhängigkeit von äußeren Einflüssen bereitgestellt werden.

Ein weitere Vorteil bei diesem Verfahren liegt darin, dass die Schutzschicht als Maske verwendet werden kann, so dass nicht fokussierte, also hochenergetische Ionenstrahlen, sondern niederenergetische Ionenstrahlen nach Art einer Ionenbrause zum Abtrennen verwendet werden können, die eine geringere Ortsauflösung haben als die hochenergetischen Ionen beim FIB. Die erforderliche Ortsauflösung für das Abtrennen der Probe wird hier durch die Maske der Schutzschicht erreicht, die bspw. mit einem Elektronenstrahl geschrieben werden kann, der eine noch höhere Ortsauflösung hat als der FIB. Auch durch diese Elektronenstrahlabscheidung der Schutzschicht werden schon viele der oben genannten Nachteile vermieden. Bei der Ablagerung der Schutzschicht wird die Oberfläche der Probe nämlich durch die erfindungsgemäß verwendbaren Elektronen nicht so geschädigt, wie dies durch die im Stand der Technik hierfür verwendeten hochenergetischen Ionenstrahlen erfolgt.

Vor diesem Hintergrund liegt der vorliegenden Erfindung die Aufgabe zugrunde, das erwähnte Verfahren derart weiterzubilden, dass eine sichere und einfache Manipulation der Probe möglich wird.

Bei einem Verfahren der eingangs genannten Art wird diese Aufgabe erfindungsgemäß dadurch gelöst, dass in Schritt c) oder d) die Probe durch Adhäsion an eine hydrophile Fläche eines von einem Manipulator bewegten Transporthalters erfasst wird, wobei im Schritt d) die Probe mit einer hydrophoben Fläche des Transporthalters gegen die hydrophile Fläche gedrückt wird.

Bei einem Greifer der eingangs genannten Art wird diese Aufgabe erfindungsgemäß dadurch gelöst, dass er mit zwei mikromechanischen Zangenelementen versehen ist, an denen jeweils eine Nano-Backe ausgebildet oder befestigt ist, wobei die eine Backe eine hydrophile Fläche und die andere Backe eine hydrophobe Fläche aufweist, als Transporthalter zum Ergreifen einer Probe für elektronenmikroskopische Untersuchungen, insbesondere mit einem Transmissionselektronenmikroskop (TEM), wobei die andere Backe eine hydrophobe Fläche aufweist.

Bei dem erfindungsgemäßen Verfahren ist von Vorteil, dass die Probe den Beanspruchungen nicht ausgesetzt werden muss, die mit dem Befestigen am Probenträger einhergehen. Ferner steht die Probe nach der Entnahme und dem Ablegen vollständig für die nachfolgende Untersuchung zur Verfügung, es sind keine Bereiche durch einen "angelöteten" Probenträger verdeckt. Insbesondere wenn die Probe aus geometrischen Gründen zur Entnahme von dem Substrat nur an den Bereichen ergriffen werden kann, die für die nachfolgende Untersuchung wieder frei sein müssen, entfällt das umständliche und riskante Entfernen des Probenträgers von der Probe. Es ist jetzt ferner möglich, mehrere Proben nacheinander auf einem Träger abzulegen, bevor dieser zur weiteren Bearbeitung aus dem REM entnommen wird.

Es ist dann bevorzugt, wenn im Schritt c) oder d) vor dem Entfernen der Probe von dem Substrat ein feuchtes Gas auf die hydrophile Fläche geleitet wird.

Die Verwendung eines feuchten Gases gehört nicht zu der Erfindung.

Hier ist von Vorteil, dass durch das feuchte Gas ein Feuchtefilm gebildet wird, der für einen sicheren Halt der Probe an der hydrophilen Fläche sorgt. Da das neue Verfahren in einer Vakuumkammer durchgeführt wird, kann der Feuchtefilm reproduzierbar erzeugt werden, was bei dem Stand der Technik nach Overwijk et al. nicht vorgesehen ist, dort wird die Probe unter atmosphärischen Bedingungen im Lichtmikroskop manipuliert.

Weiter ist es dann bevorzugt, wenn im Schritt d) nach dem Entfernen der Probe von dem Substrat ein trockenes Gas auf die hydrophile Fläche geleitet wird.

Auf diese verfahrenstechnisch einfache Weise kann für ein sicheres Ablösen der Probe von der hydrophilen Fläche gesorgt werden. Die Probe kann so definiert abgelegt werden. Dies ist beim Stand der Technik möglich, denn unter atmosphärischen Bedingungen lässt sich die hydrophile Fläche, die Abmessungen im Nanometerbereich oder unteren Mikrometerbereich aufweist, auf diese Weise nicht reproduzierbar trocknen.

Das Drücken der Probe gegen die hydrophile Fläche mit der hydrophoben Fläche erhöht auf konstruktiv einfache Weise noch einmal die Sicherheit beim Transport der Probe, denn dies wird nicht nur durch Adhäsion sondern auch durch Klemmwirkung gehalten. Weil die zweite Fläche hydrophob ist, verbleibt die fragile Probe nach dem Öffnen der durch die beiden Flächen gebildeten Zange reproduzierbar an der hydrophilen Fläche und kann definiert abgelegt werden.

Ferner ist es bevorzugt, wenn die hydrophile Fläche einen Schlitz aufweist, wobei die Probe so auf der hydrophilen Fläche positioniert wird, dass sie über dem Schlitz zu liegen kommt, und dass die Probe nach dem Entfernen von dem Substrat auf einem in den Schlitz eingreifenden Sockel abgelegt und die hydrophile Fläche danach in Richtung des Sockels von der Probe entfernt wird.

Hier ist von Vorteil, dass die Probe definiert auf den Sockel übergeben werden kann, ohne dass die Gefahr mechanischer Beschädigung besteht.

Andererseits ist es auch möglich, die Probe auf einen Probenhalter mit Gabelstruktur abzulegen, wobei die Zinken der Gabel sozusagen beiderseits neben der hydrophilen Fläche unter die Probe greifen. Der Probenhalten mit Gabelstruktur gehört nicht zu der Erfindung.

Bei dem erfindungsgemäßen Greifer weisen die Nano-Backen vorzugsweise eine Länge von ca. 100 nm bis ca. 10 µm und eine Breite von ca. 100 nm bis ca. 10 µm auf.

Die Nano-Backen können durch EBID bzw. IBID an die vorderen Enden von Zangenelementen eines Mikrogreifers angekoppelt werden, wie er bspw. von der Fa. Nascatec GmbH, Ludwig Erhard Straße 10, 34131 Kassel, produziert und über die Fa. NanoAndMore GmbH, Merkstraße 22, 64283 Darmstadt, erhältlich ist. Andererseits ist es auch möglich, die vorderen Enden der Zangenelemente solcher Mikrogreifer mit FIB nachzubearbeiten und somit sozusagen anzuspitzen.

Bei dieser weiteren Miniaturisierung ist von Vorteil, dass die Nano-Backen am vordersten Ende der mikromechanischen Zangenelemente einen Federeffekt bewirken, so dass die Gefahr der Beschädigung der fragilen Probe weiter reduziert wird.

Es sei noch erwähnt, dass mit dem neuen Verfahren Proben präpariert werden können, die eine Dicke von ca. 5 bis ca. 200 nm und eine Länge von ca. 1 bis ca. 200 µm aufweisen. Die Höhe beträgt dabei ca. 100 nm bis ca. 100 µm.

Weitere Vorteile und Merkmale ergeben sich aus der nachstehenden Beschreibung sowie aus den beigefügten Figuren.

Es versteht sich, dass die vorstehend genannten und nachstehend noch zu erläuternden Merkmale nicht nur in der jeweils angegeben Kombination sondern auch in anderen Kombinationen oder in Alleinstellung verwendbar sind, ohne den Rahmen der vorliegenden Erfindung zu verlassen.

Ausführungsbeispiele der Erfindung sind in den Figuren dargestellt und werden in der nachfolgenden Beschreibung näher erläutert. Es zeigen:
- Fig. 1: ein Substrat in einer Seitenansicht mit gestrichelt dargestellter Probe sowie einem die Probenstelle abdeckenden Nanodraht und einem angedeuteten SAIB;
- Fig. 2: ein Substrat in einer Draufsicht mit einer Schattenmaske, die eine Probenstelle freigibt;
- Fig. 3: in schematischer Ansicht ein Substrat, bei dem auf die Oberfläche der Probenstelle eine Schutzschicht aufgebracht wird;
- Fig. 4: ein Substrat in einer schematischen Ansicht, bei dem die Probe mit einem Ionenstrahl von dem Substrat abgetrennt wird;
- Fig. 5: eine Darstellung wie Fig. 4, wobei die Probe zumindest umfänglich von dem Substrat abgetrennt ist;
- Fig. 6: eine Darstellung wie Fig. 5, wobei die Probe an der Spitze einer Nadel befestigt wird;
- Fig. 7: eine Darstellung wie Fig. 6, wobei die an der Nadel befestigte Probe von dem Substrat abgehoben wird;
- Fig. 8: in schematischer Darstellung ein Rasterelektronenmikroskop, in dem ein Substrat angeordnet ist, von dem eine Probe präpariert und analysiert werden soll;
- Fig. 9a: in Seitenansicht und Draufsicht einen TEM-Probenträger mit TEM-Trägernetz und Nadel, wie er bei den Verfahrensschritten aus den Figuren 6 und 7 verwendet werden kann;
- Fig. 9b: ein weiteres Ausführungsbeispiel für einen TEM-Probenträger, wie er bei den Verfahrensschritten aus den Fig. 6 und 7 verwendet werden kann;
- Fig. 10: eine Draufsicht auf den TEM-Probenträger aus Fig. 9, mit an der Spitze der Nadel befestigter Probe;
- Fig. 11: den TEM-Probenträger aus Fig. 10, der an dem TEM-Trägemetz von Zangenelementen eines Greifers ergriffen wird;
- Fig. 12: einen TEM-Probenstab, in den der TEM-Probenträger aus Fig. 10 eingelegt ist;
- Fig. 13: in geschnittener, schematischer Seitendarstellung eine gezogene Glaskapillare mit hydrophiler Fläche, an der die Probe aus Fig. 5 befestigt ist;
- Fig. 14: eine gezogene Glaskapillare wie in Fig. 13, wobei die hydrophile Fläche jedoch als eine über die Spitze der Glaskapillare vorstehende NanoBacke ausgebildet ist;
- Fig. 15: einen in dem Rasterelektronenmikroskop aus Fig. 8 verwendbaren Greifer mit zwei mikromechanischen Zangenelementen, an denen jeweils eine Nano-Backe befestigt ist;
- Fig. 16: eine Draufsicht auf die Spitze eines Zangenelementes aus Fig. 15, wobei die hydrophile Nano-Backe einen Schlitz aufweist, über dem die Probe zu liegen kommt; und
- Fig. 17: einen an die Nano-Backe aus Fig. 16 angepassten Sockel, auf dem die Probe abgelegt wird.

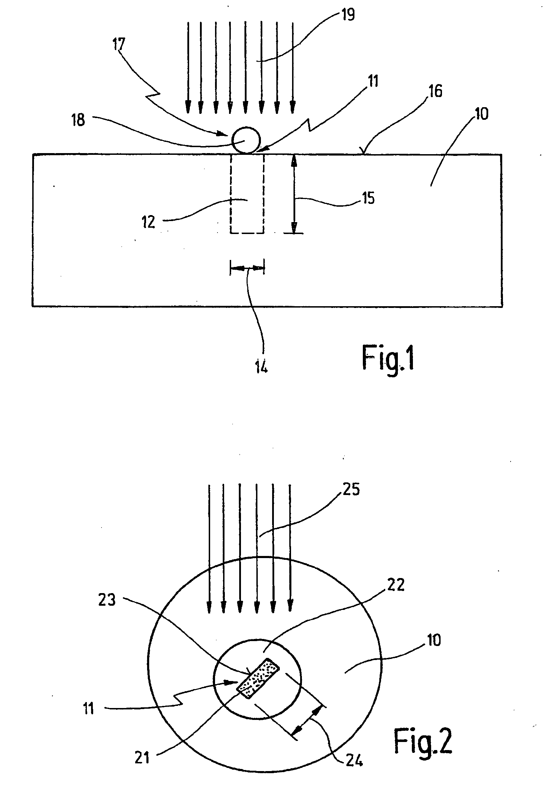

In Fig. 1 ist mit 10 ein Substrat bezeichnet, aus dem an einer Probenstelle 11 eine Probe 12 herauspräpariert werden soll, die in Fig. 1 gestrichelt dargestellt ist. Die Probe 12 soll für Untersuchungen mit einem Transmissionselektronenmikroskop (TEM) präpariert werden, wozu es erforderlich ist, sie zunächst von dem Substrat 10 zu trennen und danach mechanisch zu fixieren.

Die Probe weist eine Dicke 14 von 5 bis 200 nm sowie eine Höhe 15 von 100 nm bis 100 µm auf.

Auf einer Oberfläche 16 von Substrat 10 und damit auch Probenstelle 11 ist eine mechanische Abdeckung 17 in Form eines Nanodrahtes 18 aufgebracht, der eine Schutzschicht für die unter der Oberfläche 16 an der Probenstelle 11 herauszupräparierende Probe 12 darstellt.

Wie es weiter unten noch beschrieben wird, kann die Probe 12 jetzt mit einem bei 19 angedeuteten breiten Ionenstrahl von dem Substrat 10 abgetrennt werden. Der Ionenstrahl 19 trägt jetzt nämlich allseits von der durch den Nanodraht 18 geschützten Probe 12 Material von dem Substrat ab, wobei die Probe 12 unter der so gebildeten Schutzschicht "stehen bleibt".

Alternativ zu einer mechanischen Abdeckung 17 kann auf die Probenstelle 11 auch eine Schutzschicht 21 aufgesprüht werden, wie dies jetzt an Hand von Fig. 2 beschrieben wird. Zu diesem Zweck ist im Bereich der Probenstelle 11 auf dem Substrat 10 eine Schattenmaske 22 aufgebracht, die den Bereich um die Probenstelle 11 herum abdeckt, aber ein Fenster 23 enthält, das an die Dicke und Länge der Probe 12 angepasst ist. Die Probe erhält so eine bei 24 angedeutete Länge von 1 bis 200 µm.

Auf die Probenstelle 11 wird jetzt durch einen bei 25 angedeuteten Sprühstrahl die Schutzschicht 21 aufgebracht, die aus einem schlecht ionenätzbaren Material besteht. Nach dem Entfernen der Schattenmaske 22 kann die Probe 12 dann mit einem breiten Ionenstrahl 19 von dem Substrat 10 so abgetrennt werden, wie dies in Fig. 1 angedeutet ist.

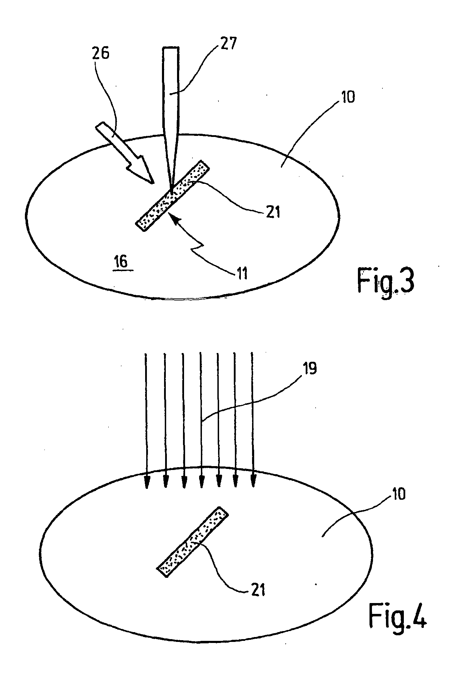

Die Schutzschicht 21 kann alternativ zu dem im Zusammenhang mit Fig. 2 beschriebenen Aufsprühen auch mit Hilfe eines fokussierten Teilchenstrahls auf der Oberfläche 16 abgeschieden werden, wie dies in Fig. 3 schematisch dargestellt ist.

Zur Erzeugung der Schutzschicht 21 wird Material aus einem sogenannten Precursor durch einen fokussierten Elektronenstrahl 27 auf der Oberfläche 16 abgeschieden. Weil der Elektronenstrahl 27 fein fokussiert ist, lässt sich die Probenstelle 11 trotz ihrer geringen Abmaße doch präzise mit einer Schutzschicht 21 aus dem schlecht ionenätzbaren Material versehen. Diese elektronenstrahlinduzierte Ablagerung (EBID) von Material ist prinzipiell bekannt, sie wird bspw. in der eingangs erwähnten Veröffentlichung von Matsui und Mori beschrieben. Als Material für die Schutzschicht 21 kommt insbesondere Wolfram, aber auch Platin, Kohlenstoffverbindungen oder allgemein metallorganische Verbindungen in Frage.

Alternativ zu einem fokussierten Elektronenstrahl 27 kann die Schutzschicht 21 auch mit einem Ionenstrahl oder mit einem Photonenstrahl abgeschieden werden, wobei die Energien jeweils so gewählt werden, dass eine Schädigung der Probe 12 vermieden oder zumindest stark minimiert wird.

Da die Schutzschicht 21 aus einem schlecht ionenätzbaren Material besteht, bietet sie bei dem nachfolgenden Abtrennen der Probe 12 von dem Substrat 10 einen hinreichenden Schutz für die so abgedeckte Probe, die jetzt mit Hilfe des breiten Ionenstrahls 19 von dem Substrat 10 abgetrennt wird, wie dies in Fig. 4 schematisch dargestellt ist. Der breite Ionenstrahl 19, der auch als Selected Area Ion Beam (SAIB) bezeichnet wird, weist eine Ionenenergie auf, die vorzugsweise kleiner als 5 keV ist. Auf diese Weise wird die Gefahr einer Schädigung der Probe 12 weiter verringert, der breite und damit niederenergetische Ionenstrahl vermag nicht durch die Schutzschicht 21 hindurch die Probe 12 zu schädigen.

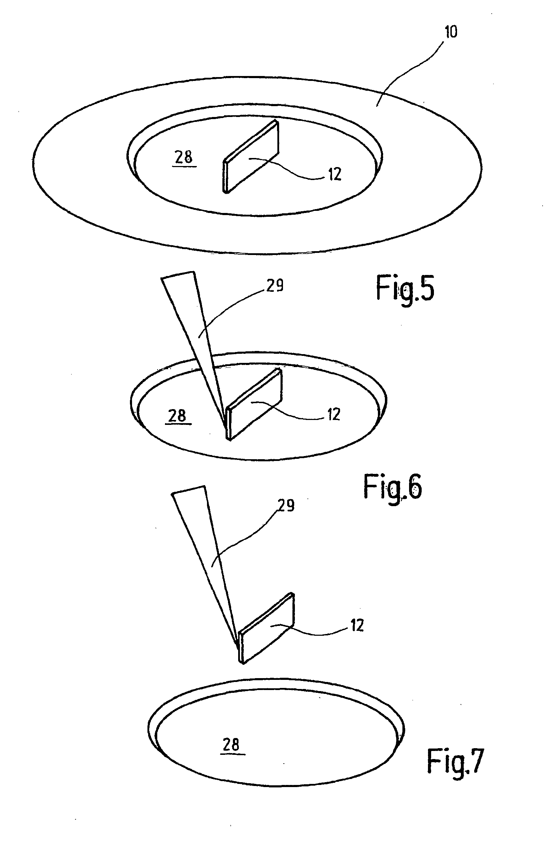

Um die Probe 12 herum entsteht in dem Substrat 10 ein bspw. kreisförmiger Bereich 28 von abgetragenem Material, so dass die Probe 12 wie eine Art Lamelle in dem Bereich 28 steht und nur noch an ihrer Unterseite mit dem Substrat 10 verbunden ist, wie dies in Fig. 5 angedeutet ist.

Die Probe 12 wird dann mit einer Spitze 29 eines Probenträgers oder Transporthalters verbunden, wie dies in Fig. 6 angedeutet ist. Die Verbindung der Probe 12 mit der Spitze 29 kann durch EBID, mit Hilfe eines Klebers oder über Oberflächenspannung erfolgen, wie dies weiter unten noch geschildert wird.

Die Probe 12 wird dann mit Hilfe der Spitze 29 aus dem Bereich 28 herausgehoben (lift out), wie dies in Fig. 7 angedeutet ist.

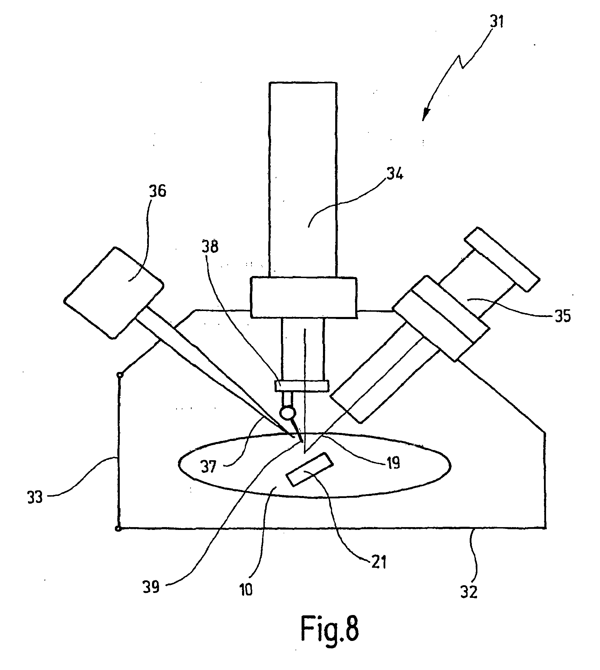

Das insoweit im Zusammenhang mit den Figuren 1 bis 7 beschriebene Präparieren der Probe 12 erfolgt unter Vakuum in einem Rasterelektronenmikroskop (REM) 31, wie es in Fig. 8 in schematischer Seitenansicht dargestellt ist.

Das REM umfasst eine Vakuumkammer 32, die über eine bei 33 angedeutete Tür von außen zugänglich ist, so dass das Substrat 10 in der Vakuumkammer 32 positioniert werden kann.

In die Vakuumkammer 32 ragt zum einen eine bei 34 angedeutete Elektronenquelle mit entsprechender Optik hinein, die sowohl zur Abbildung der Probenstelle als auch für die Ablagerung der Schutzschicht mittels EBID eingesetzt wird. Ferner ragt in die Vakuumkammer 32 eine Ionenquelle 35 hinein, mit der der breite Ionenstrahl 19 erzeugt wird, über den die Probe von dem Substrat abgetrennt wird. Ferner ist noch eine Precursor-Kammer 36 vorgesehen, die mit ihrer Gasdüse 37 in die Vakuumkammer 32 hineinragt, wo sie den Precursor abgibt, aus dem das Material für die Schutzschicht sowie ggf. zum Verbinden der Probe mit der Spitze eines Probenträgers oder Transporthalters abgeschieden wird.

Schließlich ist noch ein Manipulator 38 vorgesehen, der einen Greifer 39 trägt, der von dem Manipulator 38 im Bereich des Substrates 10 so verfahren werden kann, dass er die Probe 12 unmittelbar erfassen kann, oder aber einen Probenträger oder Transporthalter ergreifen kann, der an der Probe befestigt ist.

Sämtliche Schritte zur Präparation der Probe können in der Vakuumkammer 32 durchgeführt werden. Zunächst erfolgt die Lokalisierung der zu präparierenden Probe mit Hilfe einer Abbildung durch die Elektronenstrahlquelle 34, was ohne Schädigung der Probe möglich ist. Dann wird die Schutzschicht 21 auf dem Substrat 10 abgeschieden, was mit Hilfe der Elektronenstrahlquelle 34 sowie des Precursors erfolgt. Auch hierbei wird die Probe nicht geschädigt.

Schließlich wird die Probe mit Hilfe des breiten Ionenstrahls 19 von dem Substrat 10 abgetrennt, wobei die Probe einerseits durch die Schutzschicht 21 vor Schädigungen geschützt wird, andererseits aber bereits durch den breiten, also niederenergetischen Ionenstrahl 19 die Gefahr der Schädigung der Probe stark reduziert wird. Auch eine Schädigung durch seitlich auf die Probe auftreffende, also an der Schutzschicht 21 vorbeigeleitete Ionen ist damit nur von geringer Bedeutung.

Die Probe kann dabei entweder zunächst vollständig von dem Substrat 10 entfernt werden, bevor sie an der aus Fig. 6 bekannten Spitze 29 befestigt wird oder unmittelbar mit Hilfe des Greifers 39 erfasst wird. Andererseits ist es auch möglich, die Probe an ihrer Unterseite noch mit dem Substrat 10 in Verbindung zu lassen und zunächst die Spitze 29 an der Probe zu befestigen bzw. sie mit dem Greifer 29 zu ergreifen. In einem nächsten Verfahrensschritt wird die Probe dann endgültig von dem Substrat 10 abgetrennt, was entweder wieder mit Hilfe des Ionenstrahls 19 oder aber durch mechanisches Ausbrechen der Probe erfolgen kann.

Die Probe kann in dem REM 31 also vollständig von dem Substrat 10 abgetrennt werden, ohne dass eine Schädigung der Probe durch hochenergetische Ionen zu befürchten ist. Darüber hinaus kann die Probe noch in der Vakuumkammer 32 mechanisch bspw. an einem TEM-Probenträger fixiert werden, der dann in einen üblichen TEM-Probenstab eingelegt und dort befestigt wird. Auf diese Weise sind nur geringe Transportwege und Fixierungs- und Lösevorgänge erforderlich, so dass auch eine mechanische Schädigung der Probe weitgehend vermieden wird.

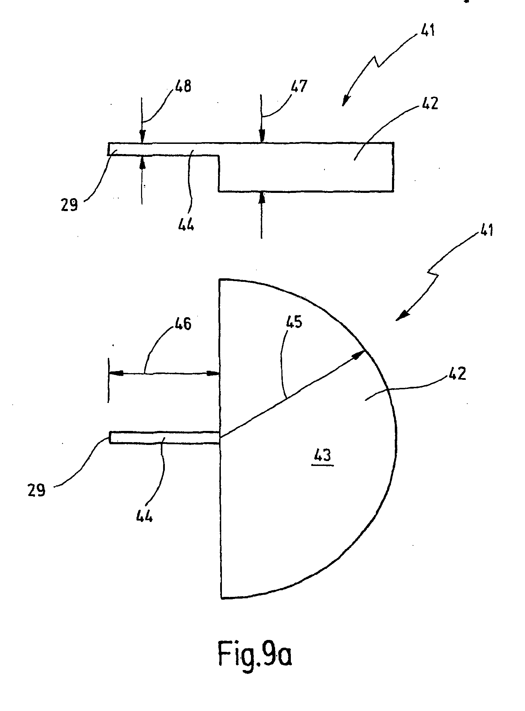

In Fig. 9a ist oben in einer Seitenansicht und unten in einer Draufsicht ein TEM-Probenträger 41 gezeigt, der sowohl zur Präparation als auch zur mechanischen Fixierung der Probe eingesetzt wird. Die Probe kann so an dem TEM-Probenträger 41 verbleiben, was die Gefahr von Beschädigungen der präparierten Probe bei den nachfolgenden Manipulation deutlich verringert.

Der TEM-Probenträger 41 weist ein dickes Halteende 42 auf, das ein halbkreisförmiges TEM-Trägernetz 43 ist, an dem einstückig eine Nadel 44 ausgebildet ist, die in die aus Fig. 6 und 7 bekannte Spitze 29 ausläuft. Das TEM-Trägernetz 43 weist einen Radius 45 auf, der im Bereich von ca. 500 µm bis ca. 2 mm liegt. Vorzugsweise ist der Radius 45 an den Standarddurchmesser von Aufnahmen in TEM-Probenstäben angepasst, der bei 2,3 oder 3,0 mm liegt. Die Nadel 45 weist eine Länge 46 auf, die im Bereich der Abmaße des Radius 45 liegt.

Bei 47 ist eine Dicke des TEM-Trägernetzes 43 angedeutet, die im Bereich von 10 µm bis 650 µm liegt, vorzugsweise entspricht sie einer Standard-Waferdicke von 635 µm.

Die Nadel 44 weist an ihrer Spitze einen Durchmesser 48 auf, der im Bereich von 100 nm bis 10 µm liegt.

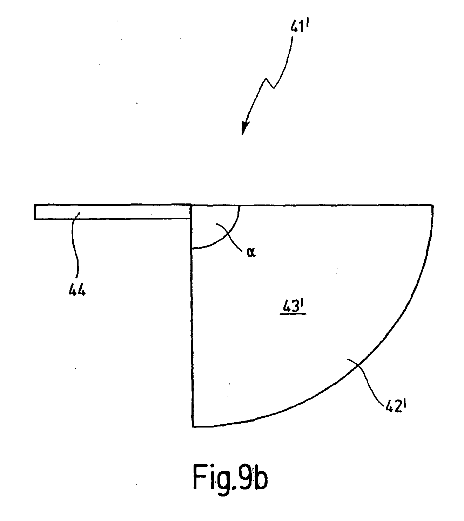

In Fig. 9b ist ein weiterer TEM-Probenträger 41' aufgezeigt, der im Querschnitt dem Aufbau des Probenträgers 41 auf Fig. 9a gleicht. Unterschiedlich vom Aufbau her ist jedoch das dicke Halteende 42', das im Gegensatz zu der Fig. 9a nicht ein halbkreisförmiges TEM-Trägernetz 43, sondern ein viertelkreisförmiges TEM-Trägernetz 43' ist.

Allgemein kann das TEM-Trägernetz 43 als Kreissegment oder -sektor ausgebildet sein, wobei sein in Fig. 9b angedeuteter Öffnungswinkel α zwischen etwa 30° und 180° liegt, gemäß Fig. 9b beträgt er vorzugsweise 90°.

Verglichen mit dem TEM-Probenträger 41 aus Fig. 9a hat der TEM-Probenträger 41' aus Fig. 9b den Vorteil, dass die von dem Halteende 42' bedeckte Fläche kleiner ist, so dass weder der Ionenstrahl 19 beim Freischneiden der Probe noch der Elektronenstrahl 25 aus der Elektronenquelle 34 bei der Abbildung der Probenstelle behindert wird.

Ein Verfahren, mit dem prinzipiell der TEM-Probenträger 41 aus Fig. 9a oder b hergestellt werden kann, ist aus der eingangs erwähnten US 6,066,265 bekannt.

Das Halteende 42, 42' kann statt als TEM-Trägernetz 43 bzw. 43' auch als metallische Scheibe bzw. Folie in Form eines Winkelsegmentes, also bspw. eines Halb- oder Viertelkreises ausgebildet sein. Bspw. ist es möglich, eine Viertelkreisscheibe aus Kupferfolie mit einer Dicke von etwa 70 µm zu verwenden, an die ein dünner Wolframdraht mit einem Durchmesser von 50 µm als Nadel angeklebt ist, der in eine dünne Spitze von bspw. 10 µm ausläuft. Andererseits ist es auch möglich, auch die Viertelscheibe aus Wolframfolie herzustellen, so dass die Nadel mit dieser einstückig auf mikrotechnische Weise hergestellt werden kann.

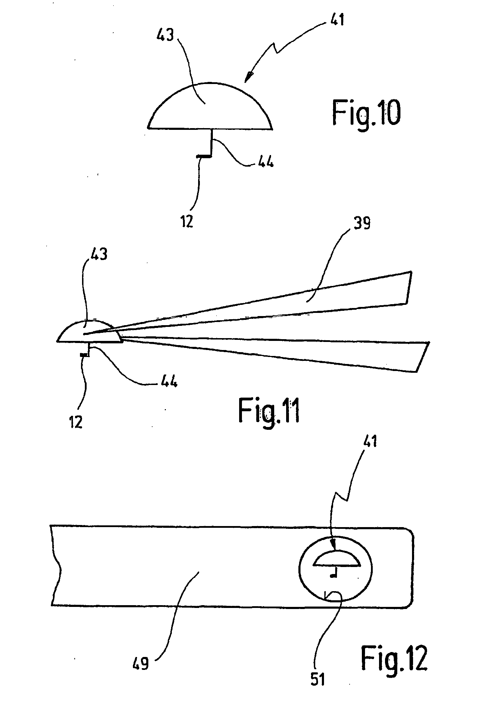

In Fig. 10 ist der TEM-Probenträger 41 aus Fig. 9a gezeigt, wobei an der Nadel 44 jetzt eine Probe 12 befestigt ist. Diese Befestigung der Probe 12 an der Nadel 44 kann durch EBID oder durch einen Klebertropfen erfolgen.

Der TEM-Probenträger 41 wird jetzt an dem TEM-Trägernetz 43 von dem aus Fig. 8 bekannten Greifer 39 ergriffen, was in Fig. 11 dargestellt ist.

Der von dem Manipulator 38 aus Fig. 8 bewegte Greifer 39 legt den TEM-Probenträger 41 jetzt in einen in einem TEM-Probenstab 49 vorgesehenen Aufnahmeraum 5 1 ein, wo der TEM-Probenträger 41 an seinem TEM-Trägernetz mechanisch fixiert wird. Dies kann durch eine gefederte Klappe oder durch einen Gewindering erfolgen, wie dies an sich bekannt ist.

In der Abfolge der Figuren 7 bis 12 ist der Übergang von der durch die Probe 12 repräsentierten Nanowelt und der Mikrowelt, wie sie durch das TEM-Trägernetz 43, 43' verkörpert ist, dargestellt. Über den Greifer 39 und den TEM-Probenstab 49 erfolgt dann der Übergang zur Makrowelt.

Der TEM-Probenträger 41, 41' stellt damit das wichtige Verbindungsglied zwischen der Nanowelt und der Makrowelt dar, wobei die Probe 12 nur einmal an der Nadel 44 befestigt werden muss, alle weiteren Schritte erfolgen ohne nochmalige unmittelbare Manipulation an der Probe 12.

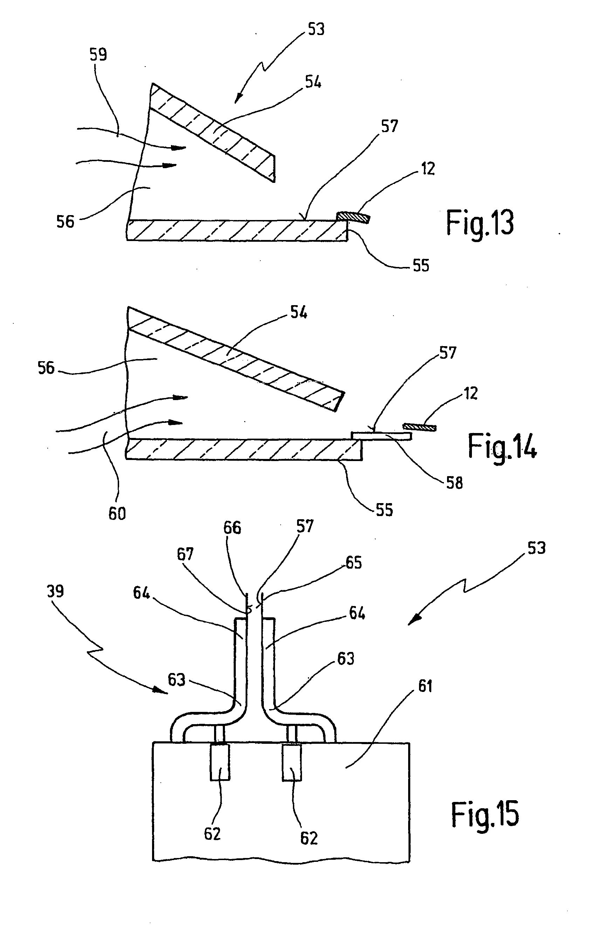

Alternativ zu der insoweit beschriebenen Befestigung der Probe 12 an einem Probenträger kann die Probe 12 auch durch Adhäsion an eine hydrophile Fläche eines von dem Manipulator 38 aus Fig. 8 bewegten Transporthalters 53 erfasst werden. Als Transporthalter 53 kann bspw. eine gezogene Glaskapillare verwendet werden, wie sie als Patch-Pipette 54 aus der Patch-Clamp-Technik bekannt ist. Eine derartige Patch-Pipette 54 ist in den Figuren 13 und 14 im Bereich ihrer Spitze 55 in stark vergrößerter, schematischer Seitenansicht gezeigt. In an sich bekannter Weise besteht die Patch-Pipette 54 aus einem an seiner Spitze 55 offenen Röhrchen 56, wobei an der Spitze 55 eine hydrophile Fläche 57 ausgebildet oder befestigt ist. In dem Ausführungsbeispiel gemäß Fig. 13 ist die hydrophile Fläche 57 Teil der Patch-Pipette 54, während die hydrophile Fläche 57 bei dem Ausführungsbeispiel gemäß Fig. 14 an einer Nano-Backe 58 ausgebildet ist, die durch EBID bzw. IBID an der Patch-Pipette 54 befestigt ist. Die Glaskapillare gehört nicht zu der Erfindung.

Die Probe 12 haftet durch Adhäsion an der hydrophilen Fläche 57, so dass sie nicht Beanspruchungen ausgesetzt sind, die bei dem Befestigen an Probenträgern auftreten können.

Um für einen sicheren Halt der Probe 12 an der hydrophilen Fläche 57 zu sorgen, wird durch das Röhrchen 57 ein feuchtes Gas 59 geleitet. Da das Ergreifen der Probe 12 mit Hilfe der Patch-Pipette 54 noch in der Vakuumkammer 32 aus Fig. 8 erfolgt, kann durch das feuchte Gas 59 reproduzierbar ein Feuchtefilm gebildet werden, der für einen sicheren Halt der Probe 12 an der hydrophilen Fläche 57 sorgt.

Um die Probe 12 reproduzierbar und ohne mechanische Belastungen von der hydrophilen Fläche 57 wieder entfernen zu können, wird ein trockenes Gas 60 durch das Röhrchen 56 geleitet, was in Fig. 14 gezeigt ist. Durch dieses trockene Gas 60 wird der Feuchtefilm von der hydrophilen Fläche 57 abgetrocknet, so dass sich die Probe 12 wieder von der hydrophilen Fläche 57 löst, so dass die Probe definiert abgelegt werden kann.

Als Transporthalter 53 kann auch der aus Fig. 8 bekannte Greifer 39 verwendet werden, der in einer schematischen Draufsicht in Fig. 15 gezeigt ist.

Der Greifer 39 ist ein mikromechanischer Greifer, der an einer Platine 61 ausgebildet ist, auf der zwei elektrostatische Aktoren 62 vorgesehen sind, über die zwei mikromechanische Zangenelemente 63 nach Art einer Zange geöffnet und geschlossen werden können. Ein derartiger Mikrogreifer wird bspw. von der eingangs erwähnten Firma Nascatec, Kassel, produziert.

Die Zangenelemente 63 weisen an ihrer Spitze 64 jeweils eine Nano-Backe 65 bzw. 66 auf. Die Nano-Backen 65 und 66 können entweder über Nacharbeiten der Spitzen 64 mit FIB hergestellt werden, wobei die Nano-Backen 65, 66 andererseits mit Hilfe von EBID bzw. IBID an die Spitzen 64 angekoppelt werden können. Bei dem erfindungsgemäßen Greifer ist die Nano-Backe 65 mit der hydrophilen Fläche 57 versehen, während die Nano-Backe 66 eine hydrophobe Fläche 67 aufweist. Auf diese Weise ist es möglich, die Probe 12 zunächst mit Hilfe der hydrophilen Fläche 57 der Nano-Backe 65 aufzunehmen und die Probe danach mit Hilfe der hydrophoben Fläche 67 der Nano-Backe 66 einzuklemmen. So bleibt die Probe 12 beim Transport innerhalb der Vakuumkammer sicher gehalten.

Zum Ablegen der Probe wird dann zunächst der Greifer 39 geöffnet, wobei die Probe reproduzierbar an der hydrophilen Fläche 57 "kleben" bleibt. Durch Einleiten eines trockenen Gases kann die Probe dann definiert abgelegt werden.

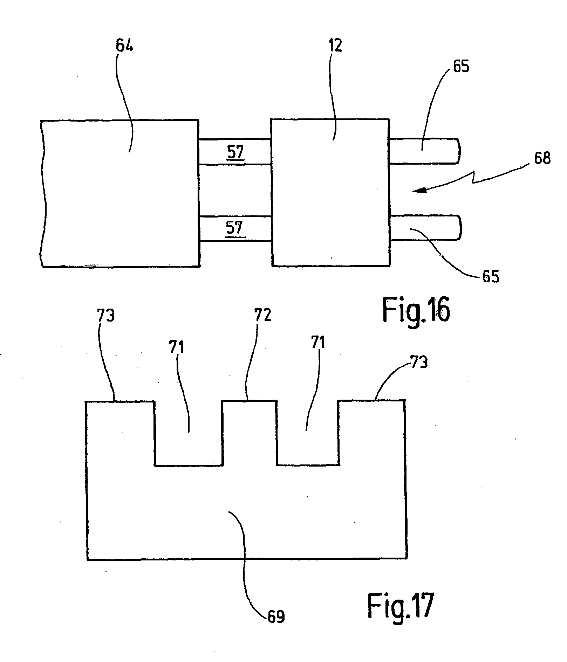

In Fig. 16 ist eine Draufsicht auf die Spitze 64 des Zangenelementes 63 aus Fig. 15 gezeigt. An der Spitze 64 sind zwei Nano-Backen 65 so befestigt, dass sie zwischen sich einen Schlitz 68 aufweisen, über dem die Probe 12 zu liegen kommt. Auf diese Weise kann die Probe 12 definiert und beschädigungsfrei auf einem in Fig. 17 gezeigten Sockel 69 abgelegt werden, wobei die beiden Nano-Backen 65 dabei in zwei Vertiefungen 71 hineinfahren, so dass die Probe 12 auf einem zwischen den beiden Vertiefungen 71 ausgebildeten Steg 72 sowie ggf. auf seitlichen Stegen 73 zu liegen kommt. Auf diese Weise ist eine definierte Ablage der Probe 12 auf dem Sockel 69 möglich. Wenn das Ablösen der Probe 12 von den hydrophilen Flächen 57 dabei noch durch ein umspülendes trockenes Gas unterstützt wird, besteht auch beim Ablegen der Probe 12 keine Beschädigungsgefahr.

## Patentansprüche

1. Verfahren zur Präparation einer Probe (12) für elektronenmikroskopische Untersuchungen, insbesondere mit einem Transmissionselektronenmikroskop (TEM), mit den Schritten:
a) ein die zu präparierende Probe (12) an einer Probenstelle (11) enthaltendes Substrat (10) wird in einer Vakuumkammer (32) bereitgestellt,
b) auf eine Oberfläche (16) der Probenstelle (11) wird eine Schutzschicht (21) aufgebracht,
c) die unter der Schutzschicht (21) befindliche Probe (12) wird durch einen Ionenstrahl (19) von dem Substrat (10) abgetrennt, wobei die Schutzschicht (21) als Maske dient, und
d) die abgetrennte Probe (12) wird in der Vakuumkammer (32) von dem Substrat (10) entfernt,
wobei in Schritt c) oder d) die Probe (12) durch Adhäsion an eine hydrophile Fläche (57) eines von einem Manipulator (38) bewegten Transporthalters (53) erfasst wird,
**dadurch gekennzeichnet, dass** als Transporthalter (53) ein Greifer (39) mit zwei Nano-Backen (65, 66) verwendet wird, dessen eine Backe (65) die hydrophile Fläche (57) und dessen andere Backe (66) die hydrophobe Fläche (67) aufweist und dass im Schritt d) die Probe (12) mit einer hydrophoben Fläche (67) des Transporthalters (53) gegen die hydrophile Fläche (57) gedrückt wird.

2. Verfahren nach Anspruch 1, **dadurch gekennzeichnet, dass** im Schritt d) nach dem Entfernen der Probe (12) von dem Substrat (10) ein trockenes Gas (60) auf die hydrophile Fläche (57) geleitet wird.

3. Verfahren nach einem der Ansprüche 1 bis 2, **dadurch gekennzeichnet, dass** die hydrophile Fläche (57) einen Schlitz (68) aufweist, wobei die Probe (12) so auf der hydrophilen Fläche (57) positioniert wird, dass sie über dem Schlitz (68) zu liegen kommt, und dass die Probe (12) nach dem Entfernen von dem Substrat (10) auf einem in den Schlitz (68) eingreifenden Sockel (69) abgelegt und die hydrophile Fläche (57) danach in Richtung des Sockels (69) von der Probe (12) entfernt wird.

4. Greifer mit zwei mikromechanischen Zangenelementen (63), an denen jeweils eine Nano-Backe (65, 66) befestigt ist, wobei die eine Backe (65) eine hydrophile Fläche (57) aufweist, als Transporthalter (53) zum Ergreifen einer Probe (12) für elektronenmikroskopische Untersuchungen, insbesondere mit einem Transmissionselektronenmikroskop (TEM), **dadurch gekennzeichnet, dass** die andere Backe (66) eine hydrophobe Fläche (67) aufweist.

5. Greifer nach Anspruch 4, **dadurch gekennzeichnet, dass** die Nano-Backen (65, 66) eine Länge von ca. 100 nm bis ca. 10 µm und eine Breite von ca. 100 nm bis ca. 10 µm aufweist.

## Claims

1. Method for preparing a sample (12) for electron microscopic examinations, in particular with a transmission electron microscope (TEM), having the steps:
a) a substrate (10) containing the sample (12) to be prepared on a sample position (11) is provided in a vacuum chamber (32),
b) a protective layer (21) is applied onto a surface (16) of the sample position (11),
c) the sample (12) located under the protective layer (21) is separated from the substrate (10) by an ion beam (19), the protective layer (21) acting as a mask, and
d) the separated sample (12) is removed from the substrate (10) in the vacuum chamber (32)
wherein in step c) or d), the sample (12) is held by adhesion on a hydrophilic surface (57) of a transport holder (53) moved by a manipulator (38),
**characterized in that** a gripper (39) having two nano-jaws (65, 66) is used as the transport holder (53), one jaw (65) of which comprises the hydrophilic surface (57) and the other jaw (66) of which comprises the hydrophobic surface (67) and **in that** the sample (12) is pressed by a hydrophobic surface (67) of the transport holder (53) against the hydrophilic surface (57) in step d).

2. Method according to Claim 1, **characterized in that** in step d), a dry gas (60) is directed onto the hydrophilic surface (57) after removal of the sample (12) from the substrate (10).

3. Method according to either of Claims 1 and 2, **characterized in that** the hydrophilic surface (57) has a slot (68), the sample (12) being positioned on the hydrophilic surface (57) so that it comes to lie over the slot (68), and **in that** the sample (12) is placed on a base (69) engaging in the slot (68) after removal from the substrate (10) and the hydrophilic surface (57) is then removed from the sample (12) in the direction of the base (69).

4. Gripper having two micromechanical pincer elements (63) on which a nano-jaw (65, 66) is respectively fastened, one jaw (65) comprising a hydrophilic surface (57), as a transport holder (53) for gripping a sample (12) for electron microscopic examinations, in particular with a transmission electron microscope (TEM), **characterized in that** the other jaw (66) comprises a hydrophobic surface (67).

5. Gripper according to Claim 4, **characterized in that** the nano-jaws (65, 66) have a length of from approximately 100 nm to approximately 10 µm and a width of from approximately 100 nm to approximately 10 µm.

## Revendications

1. Procédé de préparation d'un échantillon (12) pour des recherches au microscope électronique, en particulier avec un microscope électronique à transmission (MET), comportant les étapes suivantes:
a) on prépare dans une chambre sous vide (32) un substrat (10) contenant l'échantillon à préparer (12) à un point d'échantillon (11),
b) on dépose une couche de protection (21) sur une surface (16) du point d'échantillon (11),
c) on sépare l'échantillon (12) se trouvant sous la couche de protection (21) du substrat (10) au moyen d'un faisceau ionique (19), la couche de protection (21) servant de masque, et
d) on éloigne l'échantillon séparé (12) du substrat (10) dans la chambre sous vide (32), dans lequel, à l'étape c) ou d), on saisit l'échantillon (12) par adhérence à une face hydrophile (57) d'un support de transport (53) déplacé par un manipulateur (38),
**caractérisé en ce que** l'on utilise comme support de transport (53) une pince (39) avec deux nano-mâchoires (65, 66), dont une mâchoire (65) présente la face hydrophile (57) et dont l'autre mâchoire (66) présente la face hydrophobe (67) et **en ce qu'**à l'étape d) on presse l'échantillon (12) avec une face hydrophobe (67) du support de transport (53) contre la face hydrophile (57).

2. Procédé selon la revendication 1, **caractérisé en ce qu'**à l'étape d), après l'éloignement de l'échantillon (12) du substrat (10), on conduit un gaz sec (60) sur la face hydrophile (57).

3. Procédé selon une des revendications 1 à 2, **caractérisé en ce que** la face hydrophile (57) présente une fente (68), dans lequel on positionne l'échantillon (12) sur la face hydrophile (57) d'une manière telle qu'il vienne se placer au-dessus de la fente (68), et **en ce que** l'on dépose l'échantillon (12), après son éloignement du substrat (10), sur un socle (69) s'engageant dans la fente (68) et on éloigne ensuite la face hydrophile (57) de l'échantillon (12) en direction du socle (69).

4. Pince avec deux éléments de pinçage micromécaniques (63), sur lesquels est respectivement fixée une nano-mâchoire (65, 66), dans laquelle une mâchoire (65) présente une face hydrophile (57) comme support de transport (53) destiné à saisir un échantillon (12) pour des recherches au microscope électronique, en particulier avec un microscope électronique à transmission (MET), **caractérisé en ce que** l'autre mâchoire (66) présente une face hydrophobe (67).

5. Pince selon la revendication 4, **caractérisée en ce que** les nano-mâchoires (65, 66) présentent une longueur d'environ 100 nm à environ 10 µm et une largeur d'environ 100 nm à environ 10 µm.
